(19)

Europäisches
Patentamt
European
Patent Office
Office européen
des brevets

(11) **EP 4 564 030 A1**

(12) **EUROPEAN PATENT APPLICATION**
published in accordance with Art. 153(4) EPC

(43) Date of publication:
04.06.2025 Bulletin 2025/23

(21) Application number: 23939225.1

(22) Date of filing: 10.10.2023

(51) International Patent Classification (IPC):
$G01R\ 31/367^{(2019.01)}$   $G01R\ 31/36^{(2020.01)}$
$G01R\ 31/396^{(2019.01)}$   $G01R\ 31/388^{(2019.01)}$
$G01R\ 31/389^{(2019.01)}$

(86) International application number:
PCT/CN2023/123733

(87) International publication number:
WO 2024/244252 (05.12.2024 Gazette 2024/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.05.2023 CN 202310640090

(71) Applicant: Deepal Automobile Technology Co.,
Ltd.
Chongqing 401133 (CN)

(72) Inventors:
• LI, Dongjiang
  Chongqing 401135 (CN)
• LI, Zonghua
  Chongqing 401135 (CN)

(74) Representative: Potter Clarkson
Chapel Quarter
Mount Street
Nottingham NG1 6HQ (GB)

(54) **METHOD AND APPARATUS FOR ESTIMATING CAPACITY OF BATTERY CELL, AND SERVER AND STORAGE MEDIUM**

(57)     A method and apparatus for estimating the capacity of a battery cell, and a server and a storage medium. The method comprises: acquiring actual charging data of a battery cell within one or more state-of-charge (SOC) intervals (S101); according to the actual charging data within each SOC interval, generating an actual charging voltage curve of the corresponding SOC interval, querying a pre-established voltage feature database by using each SOC interval as an index, and outputting a reference charging voltage curve of each SOC interval (S102); and calculating the actual capacity of the battery cell according to the actual charging voltage curve and reference charging voltage curve of each SOC interval (S103). By means of the method, the problems in the relevant art of methods for calculating the capacity of a battery cell being affected by battery systems, the calculation accuracy being relatively low, etc., are solved.

FIG. 1

EP 4 564 030 A1

**Description**

## CROSS-REFERENCE TO RELATED APPLICATION

This application is submitted based on and claims priority to Chinese Patent Application No. 202310640090.X, filed on May 31, 2023, the entire disclosure of which is incorporated herein by reference.

## TECHNICAL FIELD

The present disclosure relates to the field of battery management system technologies, and particularly, to a method and device for estimating a capacity of a battery cell, a server, and a storage medium.

## BACKGROUND

A battery pack generally contains dozens or even hundreds of battery cells. A capacity of the battery pack is determined by a capacity of each battery cell. Accurately calculating the capacity of each battery cell can not only acquire a capacity fade condition of each battery cell during use but also enable calculation of a current capacity of the battery pack based on a capacity of the battery cell calculated in real time and further accurate calculation of SOH (State of Health) of a battery.

Since the battery pack is controlled through a highest voltage and a lowest voltage of the battery cell during charging/discharging, when the capacity and a SOC (State of charge) of each battery cell in the battery pack are inconsistent, it is impossible to acquire the capacity of each battery cell by simple charging and discharging.

In the related art, a total capacity of the battery cell is calculated by using a correspondence $\Delta V \sim \Delta Q$ between voltage and capacity during constant current charging (discharging). However, this method is effective for a battery system such as Nickel Manganese Cobalt, NMC (a ternary material), but not for a lithium iron phosphate (LiFePO4, LFP) battery system. A voltage curve of the LFP battery system is extremely flat, which makes a correspondence $\Delta V \sim \Delta Q$ within a voltage plateau region keenly sensitive. A slight change in voltage may cause a significant change in capacity, resulting in a large error in the estimation of the capacity.

## SUMMARY

The present disclosure provides a method and device for estimating a capacity of a battery cell, a server, and a storage medium to solve problems that a method for calculating a capacity of a battery cell is affected by a battery system and calculation accuracy is lower in the related art.

A method for estimating a capacity of a battery cell is provided according to embodiments in a first aspect of the present disclosure. The method is applied in a server. The method includes: acquiring actual charging data of the battery cell within one or more SOC intervals; generating, based on the actual charging data within each of the one or more SOC intervals, an actual charging voltage curve of a corresponding SOC interval, querying a pre-established voltage feature database with each of the one or more SOC intervals as an index, and outputting a reference charging voltage curve of each of the one or more SOC intervals; and calculating an actual capacity of the battery cell based on the actual charging voltage curve and the reference charging voltage curve of each of the one or more SOC intervals.

According to the above technical means, in the embodiments of the present disclosure, the actual capacity of the battery cell can be accurately calculated by comparing the actual charging voltage curve of the battery cell with the corresponding reference charging voltage curve. Since a pre-calibrated standard reference charging voltage curve is used, the actual capacity of the battery cell can be accurately obtained through the comparison, based on the voltage curve, avoiding an influence of the battery system on the estimation result, which is effectively applicable to a plurality of battery systems. At the same time, the estimation method according to the embodiments of the present disclosure can be deployed in the server, and calculation efficiency is improved by using computing resources of the server.

Optionally, the calculating the actual capacity of the battery cell based on the actual charging voltage curve and the reference charging voltage curve of each of the one or more SOC intervals includes: calculating a root-mean-square error of the battery cell based on the actual charging voltage curve and the reference charging voltage curve of each of the one or more SOC intervals, and determining an objective function based on the root-mean-square error; and finding, by using a least squares method, an optimal solution to the objective function to obtain the actual capacity of the battery cell.

According to the above technical means, in the embodiments of the present disclosure, the root-mean-square error can be calculated by using the actual charging voltage curve and the reference charging voltage curve and the objective function is determined by using the root-mean-square error; and the actual capacity of the battery cell is calculated by using the least squares method for the optimal solution.

Optionally, the calculating the root-mean-square error of the battery cell based on the actual charging voltage curve and the reference charging voltage curve of each of the one or more SOC intervals includes: dividing a total charging time period of a reference battery cell into different charging stages; adding an interval identifier to a SOC interval corresponding to each of the different charging stages, and establishing a mathematical expression among SOC interval, SOC, and capacity based on the interval identifier; and extracting the actual charging voltage curve and the corresponding reference charging voltage curve by using the mathematical expression, and calculating the root-mean-square error of the battery cell based on respective mathematical expressions of the actual charging voltage curve and the reference charging voltage curve of each of the one or more SOC intervals.

According to the above technical means, in the embodiments of the present disclosure, the total charging time period of the reference battery cell can be divided into the different charging stages; the interval identifiers are set for the SOC intervals of the different charging stages; the mathematical expressions of the different SOC intervals are established; the actual charging voltage curve and the corresponding reference charging voltage curve are further extracted by using the mathematical expressions; and the root-mean-square error is calculated based on the respective mathematical expressions of the actual charging voltage curve and the reference charging voltage curve of each SOC interval.

Optionally, the method further includes, prior to the querying the pre-established voltage feature database: constructing a charging test matrix of temperature and charging current; acquiring, based on the charging test matrix, charging voltage curves at different charging temperatures and/or different charging rates, performing interpolation on the charging voltage curves at the different temperatures and/or the different charging rates to obtain a plurality of reference charging voltage curves; and constructing the voltage feature database based on each of the one or more SOC intervals and a corresponding one of the plurality of reference charging voltage curves.

According to the above technical means, in the embodiments of the present disclosure, the charging test matrix can be constructed from the two dimensions of the temperature and the charging current; the interpolation is performed on the charging voltage curves at the different charging temperatures and the different charging rates that are obtained by means of the charging matrix, to obtain the plurality of reference charging voltage curves; and the voltage feature database is constructed by using the plurality of reference charging voltage curves and the SOC intervals to facilitate subsequent lookup of the corresponding reference charging voltage curves based on the SOC intervals.

Optionally, the performing the interpolation on the charging voltage curves at the different temperatures and/or the different charging rates to obtain the plurality of reference charging voltage curves includes: calculating a maximum charging capacity corresponding to all the charging voltage curves at the different rates; determining, based on the maximum charging capacity, a step size of a capacity interval corresponding to each of all the charging voltage curves, and dividing the capacity interval into a plurality of grids based on the step size; and calculating a first constant based on a voltage of each of the plurality of grids, acquiring, based on the first constant, a charging voltage at an arbitrary charging current, and generating the plurality of reference charging voltage curves based on the charging voltage at the arbitrary charging current.

According to the above technical means, in the embodiments of the present disclosure, the interpolation can be performed on the charging voltage curves at the different charging rates, and the reference charging voltage curve corresponding to the charging voltage at the arbitrary charging current is calculated with a formula.

Optionally, the performing the interpolation on the charging voltage curves at the different temperatures and/or the different charging rates to obtain the plurality of reference charging voltage curves further includes: calculating a maximum charging capacity corresponding to all the charging voltage curves at the different temperatures; determining, based on the maximum charging capacity, a step size of a capacity interval corresponding to each of all the charging voltage curves, and dividing the capacity interval into a plurality of grids based on the step size; and calculating a second constant based on a voltage of each of the plurality of grids, acquiring, based on the second constant, a voltage curve at an arbitrary temperature, and obtaining the plurality of reference charging voltage curves based on the voltage curve at the arbitrary temperature.

According to the above technical means, in the embodiments of the present disclosure, the interpolation can be performed on the charging voltage curves at the different temperatures, and the reference charging voltage curve corresponding to the voltage curve at the arbitrary temperature is calculated with a formula.

Optionally, the acquiring, based on the charging test matrix, the charging voltage curves at the different charging temperatures and/or the different charging rates includes: at a predetermined temperature, performing constant current discharging with a first predetermined current until a predetermined cut-off voltage is reached, switching to a second predetermined current to perform the constant current discharging until the predetermined cut-off voltage is reached, standing for a first predetermined duration, performing the constant current charging with a third predetermined current until the predetermined cut-off voltage is reached, and recording a charging voltage curve at a current temperature and/or a current charging rate; and standing for a second predetermined duration, performing the constant current discharging with a fourth predetermined current until the predetermined cut-off voltage is reached, switching to a fifth predetermined current to perform the constant current discharging until the predetermined cut-off voltage is reached, standing for a third predetermined duration, and re-performing a charging test at other charging rates and/or other charging temperatures.

According to the above technical means, in the embodiments of the present disclosure, the charging voltage curves at the different charging temperatures and/or the different charging rates can be acquired based on the charging test matrix to facilitate subsequent acquisition of the reference charging voltage curve based on the charging voltage curve.

A method for estimating a capacity of a battery cell is provided according to embodiments in a second aspect of the present disclosure. The method is applied in a server. The method includes: constructing a charging test matrix of temperature and charging current; acquiring, based on the charging test matrix, charging voltage curves at different charging temperatures and/or different charging rates, performing interpolation on the charging voltage curves at the different temperatures and/or the different charging rates to obtain a reference charging voltage curve of each SOC interval; and constructing a voltage feature database based on the reference charging voltage curve of each SOC interval, querying the reference charging voltage curve of each SOC interval by using the voltage feature database, and calculating an actual capacity of the battery cell based on an actual charging voltage curve and the reference charging voltage curve of each SOC interval.

A device for estimating a capacity of a battery cell is provided according to embodiments in a third aspect of the present disclosure. The device is applied in a server. The device includes: acquiring actual charging data of the battery cell within one or more SOC intervals; generating, based on the actual charging data within each of the one or more SOC intervals, an actual charging voltage curve of a corresponding SOC interval, querying a pre-established voltage feature database with each of the one or more SOC intervals as an index, and outputting a reference charging voltage curve of each of the one or more SOC intervals; and calculating an actual capacity of the battery cell based on the actual charging voltage curve and the reference charging voltage curve of each of the one or more SOC intervals.

Optionally, the first calculation module is further configured to: calculate a root-mean-square error of the battery cell based on the actual charging voltage curve and the reference charging voltage curve of each of the one or more SOC intervals, and determine an objective function based on the root-mean-square error; and find, by using a least squares method, an optimal solution to the objective function to obtain the actual capacity of the battery cell.

Optionally, the first calculation module is further configured to: divide a total charging time period of a reference battery cell into different charging stages; add an interval identifier to a SOC interval corresponding to each of the different charging stages, and establish a mathematical expression among SOC interval, SOC, and capacity based on the interval identifier; and extract the actual charging voltage curve and the corresponding reference charging voltage curve by using the mathematical expression, and calculate the root-mean-square error of the battery cell based on respective mathematical expressions of the actual charging voltage curve and the reference charging voltage curve of each of the one or more SOC intervals.

Optionally, the device further includes a processing module. The processing module is configured to: prior to the querying the pre-established voltage feature database, construct a charging test matrix of temperature and charging current; acquire, based on the charging test matrix, charging voltage curves at different charging temperatures and/or different charging rates, and perform interpolation on the charging voltage curves at the different temperatures and/or the different charging rates to obtain a plurality of reference charging voltage curves; and construct the voltage feature database based on each of the one or more SOC intervals and a corresponding one of the plurality of reference charging voltage curves.

Optionally, the processing module is further configured to: calculate a maximum charging capacity corresponding to all the charging voltage curves at the different rates; determine, based on the maximum charging capacity, a step size of a capacity interval corresponding to each of all the charging voltage curves, and divide the capacity interval into a plurality of grids based on the step size; and calculate a first constant based on a voltage of each of the plurality of grids, acquire, based on the first constant, a charging voltage at an arbitrary charging current, and generate the plurality of reference charging voltage curves based on the charging voltage at the arbitrary charging current.

Optionally, the processing module is further configured to: calculate a maximum charging capacity corresponding to all the charging voltage curves at the different temperatures; determine, based on the maximum charging capacity, a step size of a capacity interval corresponding to each of all the charging voltage curves, and divide the capacity interval into a plurality of grids based on the step size; and calculate a second constant based on a voltage of each of the plurality of grids, acquire, based on the second constant, a voltage curve at an arbitrary temperature, and obtain the plurality of reference charging voltage curves based on the voltage curve at the arbitrary temperature.

Optionally, the processing module is further configured to: at a predetermined temperature, perform constant current discharging with a first predetermined current until a predetermined cut-off voltage is reached, switch to a second predetermined current to perform the constant current discharging until the predetermined cut-off voltage is reached, stand for a first predetermined duration, perform the constant current charging with a third predetermined current until the predetermined cut-off voltage is reached, and record a charging voltage curve at a current temperature and/or a current charging rate; and stand for a second predetermined duration, perform the constant current discharging with a fourth predetermined current until the predetermined cut-off voltage is reached, switch to a fifth predetermined current to perform the constant current discharging until the predetermined cut-off voltage is reached, stand for a third predetermined duration, and re-perform a charging test at other charging rates and/or other charging temperatures.

A device for estimating a capacity of a battery cell is provided according to embodiments in a fourth aspect of the present disclosure. The device is applied in a server. The device includes a construction module, an interpolation module, and a second calculation module. The construction module is configured to construct a charging test matrix of temperature and charging current. The interpolation module is configured to acquire, based on the charging test matrix, charging voltage curves at different charging temperatures and/or different charging rates, and perform interpolation on the charging voltage curves at the different temperatures and/or the different charging rates to obtain a reference charging voltage curve of each SOC interval. The second calculation module is configured to construct a voltage feature database based on the reference charging voltage curve of each SOC interval, query the reference charging voltage curve of each SOC interval by using the voltage feature database, and calculate an actual capacity of the battery cell based on an actual charging voltage curve and the reference charging voltage curve of each SOC interval.

A server is provided according to embodiments in a fifth aspect of the present disclosure. The server includes a memory, a processor, and a computer program stored in the memory and executable by the processor. The processor is configured to execute the computer program to implement the method for estimating the capacity of the battery cell as described in the above embodiments.

A computer-readable storage medium is provided according to embodiments in a sixth aspect of the present disclosure. The medium has a computer program stored thereon. The computer program is configured to be executed by a processor to implement the method for estimating the capacity of the battery cell as described in the above embodiments.

Therefore, the present disclosure has at least the following beneficial effects.

(1) In the embodiments of the present disclosure, the actual capacity of the battery cell can be accurately calculated by comparing the actual charging voltage curve of the battery cell with the corresponding reference charging voltage curve. Since a pre-calibrated standard reference charging voltage curve is used, the actual capacity of the battery cell can be accurately obtained by the comparison based on the voltage curve, avoiding an influence of the battery system on the estimation result, which is effectively applicable to a plurality of battery systems. At the same time, the estimation method according to the embodiments of the present disclosure can be deployed in the server, and calculation efficiency is improved by using computing resources of the server.

(2) In the embodiments of the present disclosure, the root-mean-square error can be calculated by using the actual charging voltage curve and the reference charging voltage curve, and the objective function is determined by using the root-mean-square error; and the actual capacity of the battery cell is calculated by using the least squares method for the optimal solution.

(3) In the embodiments of the present disclosure, the total charging time period of the reference battery cell can be divided into the different charging stages; the interval identifiers is set for the SOC intervals of the different charging stages; the mathematical expressions of the different SOC intervals are established; the actual charging voltage curve and the corresponding reference charging voltage curve are further extracted by using the mathematical expressions; and the root-mean-square error is calculated based on the respective mathematical expressions of the actual charging voltage curve and the reference charging voltage curve of each SOC interval.

(4) In the embodiments of the present disclosure, the charging test matrix can be constructed from the two dimensions of the temperature and the charging current; the interpolation is performed on the charging voltage curves at the different charging temperatures and the different charging rates that are obtained by means of the charging matrix, to obtain the plurality of reference charging voltage curves; and the voltage feature database is constructed by using the plurality of reference charging voltage curves and the SOC intervals to facilitate subsequent lookup of the corresponding reference charging voltage curves based on the SOC intervals.

(5) In the embodiments of the present disclosure, the interpolation can be performed on the charging voltage curves at the different charging rates, and the reference charging voltage curve corresponding to the charging voltage at the arbitrary charging current is calculated with a formula.

(6) In the embodiments of the present disclosure, the interpolation can be performed on the charging voltage curves at the different temperatures, and the reference charging voltage curve corresponding to the voltage curve at the arbitrary temperature is calculated with a formula.

(7) In the embodiments of the present disclosure, the charging voltage curves at the different charging temperatures and/or the different charging rates can be acquired based on the charging test matrix to facilitate subsequent acquisition of the reference charging voltage curve based on the charging voltage curve.

Therefore, the technical problems in the related art, such as the method for calculating the capacity of the battery cell is affected by the battery system and the calculation accuracy is lower, are solved.

Additional aspects and advantages of the present disclosure will be provided at least in part in the following description, or will become apparent in part from the following description, or can be learned from the practice of the present disclosure.

## BRIEF DESCRIPTION OF DRAWINGS

These and other aspects and advantages of the present disclosure will become apparent and more readily appreciated from the following descriptions made with reference to the accompanying drawings.

FIG. 1 is a flowchart of a method for estimating a capacity of a battery cell according to an embodiment of the present disclosure.
FIG. 2 is a schematic diagram of charging interval division and interval identifiers according to an embodiment of the present disclosure.
FIG. 3 is a flowchart of a method for estimating a capacity of a battery cell according to an embodiment of the present disclosure.
FIG. 4 is a schematic diagram of charging interval division and interval identifiers of any battery cell in an LFP battery pack provided according to an embodiment of the present disclosure.
FIG. 5 is a flowchart of a method for estimating a capacity of a battery cell according to another embodiment of the present disclosure.
FIG. 6 is an example diagram of a device for estimating a capacity of a battery cell according to an embodiment of the present disclosure.
FIG. 7 is an example diagram of a device for estimating a capacity of a battery cell according to another embodiment of the present disclosure.
FIG. 8 is a schematic diagram of a structure of a server according to an embodiment of the present disclosure.

## DESCRIPTION OF THE EMBODIMENTS

Embodiments of the present disclosure are described in detail below, examples of which are illustrated in the accompanying drawings, where the same or similar reference numerals throughout represent the same or similar elements or elements with the same or similar functions. The embodiments described below with reference to the accompanying drawings are illustrative only, and are intended to explain rather than limit the present disclosure.

A method and device for estimating a capacity of a battery cell, a server, and a storage medium according to embodiments of the present disclosure will be described below with reference to the accompanying drawings. In view of the problem mentioned in the above background technology, where the method in which the total capacity of the battery cell is calculated by using the correspondence $\Delta V \sim \Delta Q$ between the voltage and the capacity during the constant current charging (discharging) in the related art, is effective for the battery system such as the NMC but not applicable to the LFP battery system, leading to the large error in the estimation of the capacity, the present disclosure provides a method for estimating a capacity of a battery cell. In this method, an actual capacity of the battery cell is accurately calculated by comparing an actual charging voltage curve of the battery cell with a corresponding reference charging voltage curve. Since a pre-calibrated standard reference charging voltage curve is used, the actual capacity of the battery cell can be accurately obtained through the comparison, based on the voltage curve, avoiding an influence of the battery system on the estimation result, which is effectively applicable to a plurality of battery systems. Therefore, the technical problems in the related art, such as the method for calculating the capacity of the battery cell is affected by the battery system and the calculation accuracy is lower, are solved.

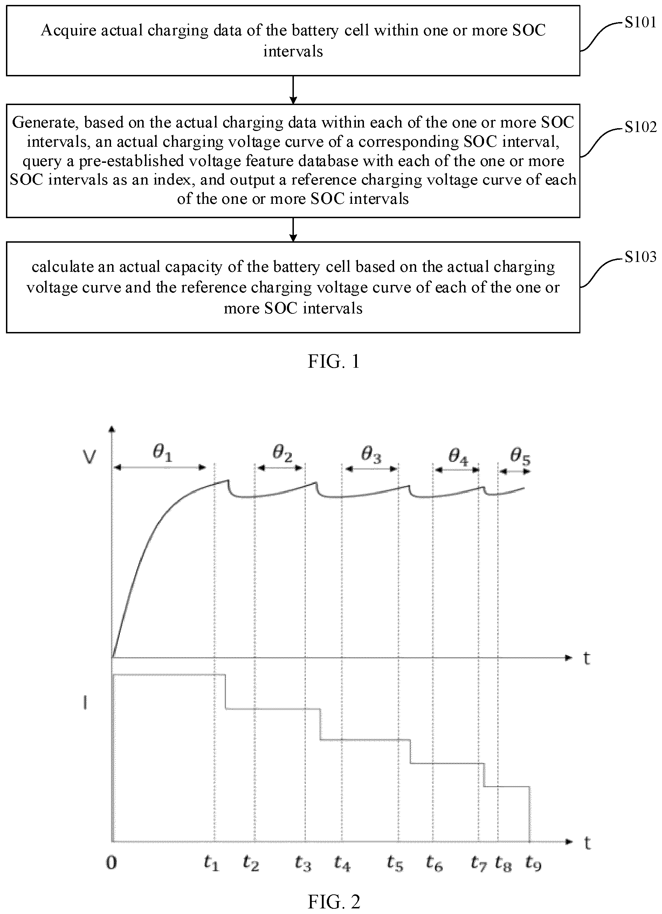

Specifically, FIG. 1 is a flowchart of a method for estimating a capacity of a battery cell according to an embodiment of the present disclosure.

As shown in FIG. 1, the method for estimating the capacity of the battery cell is applied in a server and the method includes operations at steps S101 to S103.

In step S101, acquire actual charging data of the battery cell within one or more SOC intervals.

The battery cell can be any battery cell, for example, a battery cell in an LFP battery pack, a battery cell of a nickel-metal hydride battery, a battery cell of a lithium battery, etc.

In step S102, generate an actual charging voltage curve of a corresponding SOC interval based on the actual charging data within each of the one or more SOC intervals, query a pre-established voltage feature database with each of the one or more SOC intervals as an index, and output a reference charging voltage curve of each of the one or more SOC intervals.

The voltage feature database stores a relationship between the SOC interval and the reference charging voltage curve (i.e., a standard charging voltage curve). A specific establishment method will be described in the following embodiments, and details thereof will not be repeated herein.

It can be understood that in the embodiment of the present disclosure, the actual charging voltage curve of the corresponding SOC interval can be generated based on the actual charging data of the battery cell within each SOC interval; the reference charging voltage curve corresponding to each SOC interval is queried in the pre-established voltage feature database; and a required value is subsequently calculated based on the actual charging voltage curve and the reference charging voltage curve.

In an embodiment of the present disclosure, the method further includes, prior to the querying the pre-established voltage feature database: constructing a charging test matrix of temperature and charging current; acquiring, based on the charging test matrix, charging voltage curves at different charging temperatures and/or different charging rates, performing interpolation on the charging voltage curves at the different temperatures and/or the different charging rates to obtain a plurality of reference charging voltage curves; and constructing the voltage feature database based on each of the one or more SOC intervals and a corresponding one of the plurality of reference charging voltage curves.

It can be understood that in the embodiment of the present disclosure, the charging test matrix can be constructed from the two dimensions of the temperature and the charging current, as shown in Table 1. Then, the charging voltage curves at the different temperatures and the different charging rates are acquired based on the charging test matrix, and the interpolation is performed on the charging voltage curves at the different temperatures and the different charging rates to obtain the reference charging voltage curves. Finally, the voltage feature database is constructed based on each SOC interval and the corresponding reference charging voltage curve. Table 1 is a charging test matrix table.

Table 1

| Temperature | $T_1$ | $T_2$ | $T_3$ | $T_4$ | $T_5$ | $T_6$ | $T_7$ |
|---|---|---|---|---|---|---|---|
| Charging current | $I_{11}$ | $I_{12}$ | $I_{13}$ | $I_{14}$ | $I_{15}$ | $I_{16}$ | $I_{17}$ |
| | $I_{21}$ | $I_{22}$ | $I_{23}$ | $I_{24}$ | $I_{25}$ | $I_{26}$ | $I_{27}$ |
| | $I_{31}$ | $I_{32}$ | $I_{33}$ | $I_{34}$ | $I_{35}$ | $I_{36}$ | $I_{37}$ |
| | $I_{41}$ | $I_{42}$ | $I_{43}$ | $I_{44}$ | $I_{45}$ | $I_{46}$ | $I_{47}$ |
| | $I_{51}$ | $I_{52}$ | $I_{53}$ | $I_{54}$ | $I_{55}$ | $I_{56}$ | $I_{57}$ |

Further, in an embodiment of the present disclosure, the acquiring, based on the charging test matrix, the charging voltage curves at the different charging temperatures and/or the different charging rates includes: at a predetermined temperature, performing constant current discharging with a first predetermined current until a predetermined cut-off voltage is reached, switching to a second predetermined current to perform the constant current discharging until the predetermined cut-off voltage is reached, standing for a first predetermined duration, performing the constant current charging with a third predetermined current until the predetermined cut-off voltage is reached, and recording a charging voltage curve at a current temperature and/or a current charging rate; and standing for a second predetermined duration, performing the constant current discharging with a fourth predetermined current until the predetermined cut-off voltage is reached, switching to a fifth predetermined current to perform the constant current discharging until the predetermined cut-off voltage is reached, standing for a third predetermined duration, and re-performing a charging test at other charging rates and/or other charging temperatures.

The predetermined temperature can be set based on a specific situation, which is a charging and discharging process under a thermostatic condition. The first predetermined current, the second predetermined current, the third predetermined current, the fourth predetermined current, and the fifth predetermined current can be set based on a specific situation. The first predetermined duration, the second predetermined duration and the third predetermined duration can be set based on a specific situation, which is not limited herein.

Charging temperature $T_1$ and charging rate $I_{15}$ are taken as an example, a method for acquiring the reference charging voltage curve is as follows.

1. Constant current discharging is performed at 0.3C until a predetermined cut-off voltage is reached, the constant current discharging is continuously performed by switching to 0.05C until the predetermined cut-off voltage is reached, stand for 0.5 hours, constant current charging is performed at $I_{15}$ until a cut-off voltage is reached, and a voltage curve is recorded.

2. Stand for 0.5 hours, the constant current discharging is performed at 0.3C until the cut-off voltage is reached, the constant current discharging is continuously performed by switching to 0.05C until the cut-off voltage is reached, and stand for 0.5 hours. After the charging at $I_{15}$ is completed, charging tests at other rates are restarted.

In an embodiment of the present disclosure, the performing the interpolation on the charging voltage curves at the different temperatures and/or the different charging rates to obtain the plurality of reference charging voltage curves includes: calculating a maximum charging capacity corresponding to all the charging voltage curves at the different rates; determining, based on the maximum charging capacity, a step size of a capacity interval corresponding to each of all the charging voltage curves, and dividing the capacity interval into a plurality of grids based on the step size; and calculating a first constant based on a voltage of each of the plurality of grids, acquiring, based on the first constant, a charging voltage at an arbitrary charging current, and generating the plurality of reference charging voltage curves based on the charging voltage at the arbitrary charging current.

Specifically, in an embodiment of the present disclosure, after the voltage curves at the different temperatures and the different charging rates are acquired, the interpolation processing is performed. Charging voltage curves at temperature $T_1$ and at different rates is taken as an example, an interpolation method is as follows.

A maximum charging capacity $Q_{max}$ corresponding to all charging voltage curves at different rates is calculated, and a capacity interval corresponding to all the charging curves is divided into 100 grids with a step size of $Q_{max}/100$. In each grid, the following formula is satisfied:

$$AB=V, \quad (1)$$

where A= (kb), B=(I 1)$^T$, V represents a voltage in the grid. The above linear equation is solved for k and b, and the charging voltage value at any charging current can be obtained based on k, b.

In an embodiment of the present disclosure, the performing the interpolation on the charging voltage curves at the different temperatures and/or the different charging rates to obtain the plurality of reference charging voltage curves includes: calculating a maximum charging capacity corresponding to all the charging voltage curves at the different temperatures; determining, based on the maximum charging capacity, a step size of a capacity interval corresponding to each of all the charging voltage curves, and dividing the capacity interval into a plurality of grids based on the step size; and calculating a second constant based on a voltage of each of the plurality of grids, acquiring, based on the second constant, a voltage curve at an arbitrary temperature, and obtaining the plurality of reference charging voltage curves based on the voltage curve at the arbitrary temperature.

Specifically, a charging voltage curve at charging rate $I_{11}$ is taken as an example, a plurality of reference charging voltage curves at an arbitrary temperature is acquired by the following method.

A maximum charging capacity $Q_{max}$ corresponding to all charging voltage curves at different temperatures is calculated, and a capacity interval corresponding to all the charging curves is divided into 100 grids with a step size of $Q_{max}/100$. In each grid, the following formula is satisfied:

$$V = ae^{c/T}, \quad (2)$$

The equation (2) is solved to obtain a and c, and a voltage curve at the arbitrary temperature can be acquired through a and c.

In step S103, calculate an actual capacity of the battery cell based on the actual charging voltage curve and the reference charging voltage curve of each of the one or more SOC intervals.

It can be understood that in the embodiments of the present disclosure, the reference charging voltage curve corresponding to each SOC interval is queried in the pre-established voltage feature database, and the actual capacity of the battery cell is calculated by using the actual charging voltage curve and the reference charging voltage curve. A specific calculation method is described as follows.

In an embodiment of the present disclosure, the calculating the actual capacity of the battery cell based on the actual charging voltage curve and the reference charging voltage curve of each of the one or more SOC intervals includes: calculating a root-mean-square error of the battery cell based on the actual charging voltage curve and the reference charging voltage curve of each of the one or more SOC intervals, and determining an objective function based on the root-mean-square error; and finding, by using a least squares method, an optimal solution to the objective function to obtain the actual capacity of the battery cell.

The calculating the root-mean-square error of the battery cell based on the actual charging voltage curve and the reference charging voltage curve of each of the one or more SOC intervals includes: dividing a total charging time period of a reference battery cell into different charging stages; adding an interval identifier to a SOC interval corresponding to each of the different charging stages, and establishing a mathematical expression among SOC interval, SOC, and capacity based on the interval identifier; and extracting the actual charging voltage curve and the corresponding reference charging voltage curve by using the mathematical expression, and calculating the root-mean-square error of the battery cell based on respective mathematical expressions of the actual charging voltage curve and the reference charging voltage curve of each of the one or more SOC intervals.

It can be understood that in the embodiments of the present disclosure, the total charging time period can be divided into the different charging stages based on a numerical change of an actual charging current of the reference battery cell; a SOC interval corresponding to each charging stage of the battery cell is identified, and the mathematical expression among the SOC interval, SOC, and capacity is established based on the interval identifier; the respective mathematical expressions of the corresponding actual charging voltage curve and the corresponding reference charging voltage curve of the SOC interval of the battery cell are extracted based on the mathematical expression to calculate the root-mean-square error of the battery cell; and the objective function is determined by means of the root-mean-square error, and the optimal solution to the objective function is found by using the least squares method to obtain the actual capacity of the battery cell.

Specifically, in an embodiment of the present disclosure, an entire charging process is divided into several intervals. Time point $t_1$ is in a first charging stage, a charging SOC interval corresponding to the first charging stage is recorded as $\theta_1$. Time point $t_2$ is in a second charging stage, and a charging voltage has tended to be stable at the time point $t_2$. Time point $t_3$ is a time point when a second stage charging process is about to end, and a charging SOC interval corresponding to the time period from the time point $t_2$ to the time point $t_3$ is recorded as $\theta_2$. Time point $t_4$ is in a third charging stage, and a charging voltage curve has tended to be stable at the time point $t_4$. Time point $t_5$ is a time point when a third stage charging process is about to end, and a charging SOC interval corresponding to the time period from the time point $t_4$ to the time point $t_5$ is recorded as $\theta_3$. Time interval division and corresponding SOC interval division in other stage charging processes are similar to this, recorded as $t_6$, $t_7$, $\theta_4$; $t_8$, $t_9$, $\theta_5$..., respectively, as shown in FIG. 2.

Interval expressions of different SOC charging intervals $\theta_1$, $\theta_2$, $\theta_3$, $\theta_4$ ... are established, a SOC of a battery cell numbered i at a start time point of charging is recorded as $x_0^i$, and a capacity thereof is recorded as $Q_0^i$, then the expressions of the different SOC intervals are represented as:

$$\theta_1^i \in [x_0^i, x_0^i + \frac{\int_0^{t_1} I dt}{Q_0^i}] \quad , (3)$$

$$\theta_2^i \in [x_0^i + \frac{\int_0^{t_2} I dt}{Q_0^i}, x_0^i + \frac{\int_0^{t_3} I dt}{Q_0^i}] \quad , (4)$$

$$\theta_3^i \in [x_0^i + \frac{\int_0^{t_4} I dt}{Q_0^i}, x_0^i + \frac{\int_0^{t_5} I dt}{Q_0^i}] \quad , (5)$$

$$\theta_4^i \in [x_0^i + \frac{\int_0^{t_6} I dt}{Q_0^i}, x_0^i + \frac{\int_0^{t_7} I dt}{Q_0^i}] \quad , (6)$$

$$\cdots$$

Actual charging voltage curves corresponding to different SOC intervals in a total charging voltage curve are extracted based on the interval identifiers and interval expressions. As shown in FIG. 2, actual charging voltage curves corresponding to different charging stages are extracted and recorded as $V_1^i(\theta_1^i)$, $V_2^i(\theta_2^i)$, $V_3^i(\theta_3^i)$, $V_4^i(\theta_4^i)$ ... respectively.

Further, after the actual charging voltage curves are acquired, based on temperatures and currents of the different charging stages in the actual charging process, a reference charging voltage curve (V (I, T,x)) in the voltage feature database is queried, root-mean-square error of the actual charging voltage curve ( $V_1^i(\theta_1^i)$, $V_2^i(\theta_2^i)$, $V_3^i(\theta_3^i)$, $V_4^i(\theta_4^i)$, $\cdots$ ) and the reference charging voltage curve of each battery cell is calculated, and an actual capacity $Q_0^i$ of each battery cell is calculated based on the least squares method. A calculation formula is represented as follows:

$$RLS =$$
$$\left( K_1 \sum \left( V(I_1, T_1, x) - V_1^i(\theta_1^i) \right)^2 + K_2 \sum \left( V(I_2, T_2, x) - V_2^i(\theta_2^i) \right)^2 + K_3 \sum \left( V(I_3, T_3, x) - \right. \right.$$
$$V3i\theta3i2 + K4VI4, T4, x - V4i\theta4i2 + ... 1/2 \ (7),$$

Where $K_1$, $K_2$, $K_3$, $K_4$... represent weights for optimization in each charging stage, respectively.

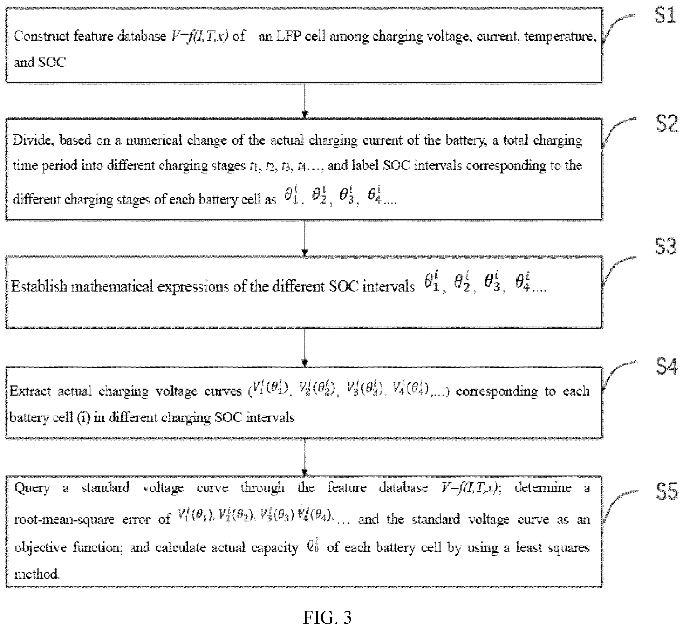

A specific example will be described below to illustrate a method for estimating a SOC of a battery cell according to embodiments of the present disclosure. As shown in FIG. 3, the method includes specific steps at S1 to S5.

At step S1, construct feature database $V=f(I,T,x)$ of an LFP battery cell about charging voltage, current, temperature, and SOC, that is, construct a feature database of a standard charging voltage curve (reference charging voltage curve) of the LFP battery cell.

1. Construction of an LFP charging test matrix

Based on a performance parameter table of a certain LFP battery cell, a charging test matrix is constructed from two dimensions of temperature and charging current, as shown in Table 2. Table 2 is an example table of a charging test matrix.

Table 2

| Temperature | -20°C | -10°C | 0°C | 10°C | 25°C | 35°C | 45°C |
|---|---|---|---|---|---|---|---|
| Charging current | 0.05C | 0.05C | 0.05C | 0.05C | 0.05C | 0.05C | 0.05C |
| | 0.1C | 0.1C | 0.1C | 0.1C | 0.1C | 0.1C | 0.1C |
| | 0.2C | 0.2C | 0.2C | 0.3C | 0.5C | 0.5C | 0.3C |
| | 0.3C | 0.3C | 0.3C | 0.5C | 1C | 1C | 0.5C |
| | 0.4C | 0.4C | 0.4C | 1C | 2C | 2C | 1C |

2. Acquisition of a standard charging voltage curve

A charging temperature of 25°C and a charging rate of 1C are taken as an example. A method for acquiring a reference charging voltage curve is as follows.

A. Constant current discharging is performed at 0.3C until a predetermined cut-off voltage is reached, the constant current discharging is continuously performed by switching to 0.05C until the predetermined cut-off voltage is reached, stand for 0.5 hours, constant current charging is performed at 1C until a cut-off voltage is reached, and a voltage curve is recorded.
B. Stand for 0.5 hours, the constant current discharging is performed at 0.3C until the cut-off voltage is reached, the constant current discharging is continuously performed by switching to 0.05C until the cut-off voltage is reached, and stand for 0.5 hours.
C. After the charging at 1C is completed, charging tests at other rates are restarted.

3. Construction of a feature database

After voltage curves at different temperatures and different charging rates are acquired, interpolation is performed to construct the voltage feature database. Charging voltage curves at a temperature of 25°C and at different rates are taken as an example. An interpolation method is as follows.

A maximum charging capacity $Q_{max}$=100Ah corresponding to all charging voltage curves at different rates is calculated, a capacity interval corresponding to all the charging curves is divided into 100 grids with a step size of 1Ah. In each grid, formula (1) is satisfied. The linear equation (1) is solved to acquire k and b, and a charging voltage at an arbitrary charging current can be acquired based on k and b.

A charging voltage curve at a charging rate of 0.1C is taken as an example, a feature database of a temperature dimension can be acquired by the following method.

A maximum charging capacity $Q_{max}$ =98Ah corresponding to all charging voltage curves at different temperatures is calculated, and a capacity interval corresponding to all the charging curves is divided into 100 grids with a step size of 0.98Ah. In each grid, formula (2) is satisfied. The equation (2) is solved to acquire a and c. A voltage curve at an arbitrary temperature can be acquired based on a and c.

At step S2, divide, based on a numerical change of the actual charging current of the battery, a total charging time period into different charging stages $t_1, t_2, t_3, t_4...$, and SOC intervals corresponding to the different charging stages of each battery cell are labeled as $\theta_1^i, \theta_2^i, \theta_3^i, \theta_4^i....$

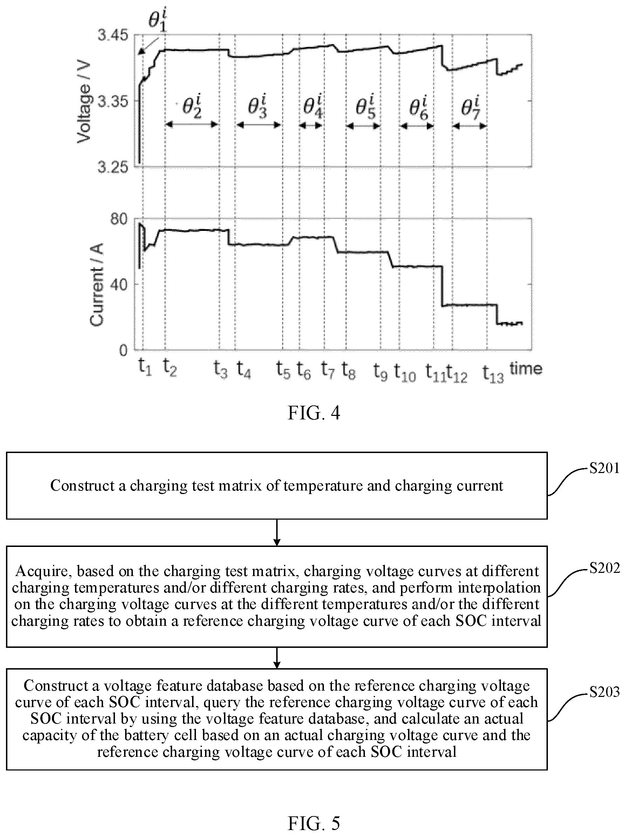

FIG. 4 is an actual charging curve of battery cell i in a certain model of an LFP battery pack, and an entire charging process is divided into 7 SOC intervals. A charging time period corresponding to $\theta_1^i$ is [0 $t_1$], a charging time period corresponding to $\theta_2^i$ is [$t_2$ $t_3$], a charging time period corresponding to $\theta_3^i$ is [$t_4$ $t_5$], a charging time period corresponding to $\theta_4^i$ is [$t_6$ $t_7$], a charging time period corresponding to $\theta_5^i$ is [$t_8$ $t_9$], a charging time period corresponding to $\theta_6^i$ is [$t_{10}$ $t_{11}$], and a charging time period corresponding to $\theta_7^i$ is [$t_{12}$ $t_{13}$]. Values of $t_1$ to $t_{13}$ are shown in Table 3, in unit of hour. Table 3 shows time periods corresponding to different divided charging process.

Table 3

| $t_1$ | $t_2$ | $t_3$ | $t_4$ | $t_5$ | $t_6$ | $t_7$ | $t_8$ | $t_9$ | $t_{10}$ | $t_{11}$ | $t_{12}$ | $t_{13}$ |
|---|---|---|---|---|---|---|---|---|---|---|---|---|
| 0.03 | 0.11 | 0.29 | 0.31 | 0.42 | 0.45 | 0.5 | 0.53 | 0.61 | 0.63 | 0.72 | 0.74 | 0.83 |

At step S3, establish interval expressions of the different SOC intervals $\theta_1^i$, $\theta_2^i$, $\theta_3^i$, $\theta_4^i$ ....

A temperature standard capacity of the selected LFP battery cell is 90 Ah. At a start time point of charging of a battery cell numbered i, a SOC (i.e. initial SOC) of the battery cell i is recorded as $x_0^i$, and a capacity thereof is recorded as $Q_0^i$, then expressions of the different SOC intervals are represented as:

$$\theta_1^i \in \left[x_0^i, x_0^i + 0.026\right],$$

$$\theta_2^i \in \left[x_0^i + 0.1, x_0^i + 0.26\right],$$

$$\theta_3^i \in \left[x_0^i + 0.28, x_0^i + 0.37\right],$$

$$\theta_4^i \in \left[x_0^i + 0.4, x_0^i + 0.44\right],$$

$$\theta_5^i \in \left[x_0^i + 0.47, x_0^i + 0.54\right],$$

$$\theta_6^i \in \left[x_0^i + 0.56, x_0^i + 0.64\right],$$

$$\theta_7^i \in \left[x_0^i + 0.66, x_0^i + 0.74\right],$$

At step S4, extract corresponding actual charging voltage curves of each battery cell (i) in different charging SOC intervals.

As shown in FIG. 4, the actual charging voltage curves corresponding to the different charging stages are extracted and recorded as $V_1^i(\theta_1^i)$, $V_2^i(\theta_2^i)$, $V_3^i(\theta_3^i)$, $V_4^i(\theta_4^i)$, $V_5^i(\theta_5^i)$, $V_6^i(\theta_6^i)$, $V_7^i(\theta_7^i)$, respectively.

At step S5, query a standard voltage curve through the feature database; determine a root-mean-square error of $V_1^i(\theta_1^i)$, $V_2^i(\theta_2^i)$, $V_3^i(\theta_3^i)$, $V_4^i(\theta_4^i)$, ... and the standard voltage curve as an objective function; and calculate $Q_0^i$ and an initial SOC of each battery cell by using a least squares method.

Reference charging voltage curve (V(I,T,x)) in the voltage feature database is queried based on temperatures and currents of the different charging stages in the actual charging process; a root-mean-square error of the actual charging voltage curve ( $V_1^i(\theta_1^i)$, $V_2^i(\theta_2^i)$, $V_3^i(\theta_3^i)$, $V_4^i(\theta_4^i)$, ... ) and the reference charging voltage curve of each battery cell is calculated; and actual capacity $Q_0^i$ of each battery cell is calculated by using the least squares method. A calculation formula is represented as follows:

$$RLS = \left( K_1 \sum \left( V(I_1, T_1, x) - V_1^i\left(\theta_1^i\right) \right)^2 + K_2 \sum \left( V(I_2, T_2, x) - V_2^i\left(\theta_2^i\right) \right)^2 + \right.$$

$$K_3 \sum \left( V(I_3, T_3, x) - V_3^i\left(\theta_3^i\right) \right)^2 + K_4 \sum \left( V(I_4, T_4, x) - V_4^i\left(\theta_4^i\right) \right)^2 + K_5 \sum \left( V(I_5, T_5, x) - \right.$$

$$\left. V_5^i\left(\theta_5^i\right) \right)^2 + K_6 \sum \left( V(I_6, T_6, x) - V_6^i\left(\theta_6^i\right) \right)^2 + K_7 \sum \left( V(I_7, T_7, x) - V_7^i\left(\theta_7^i\right) \right)^2 \right)^{1/2},$$

Where $K_1$, $K_2$, $K_3$, $K_4$, $K_5$, $K_6$, $K_7$ represent weights for optimization in each charging stage, respectively. The actual capacity $Q_0^i$ of each battery cell is calculated as shown in Table 4. Table 4 shows a capacity of each battery cell in the LFP battery pack.

Table 4

| | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|
| Battery cell number | 1 | 2 | 3 | 4 | 5 | 6 | 7 | 8 | 9 | 10 | 11 | 12 | 13 | 14 | 15 |
| Capacity y/Ah | 89.15 | 89.6 | 89.45 | 89 | 90.03 | 88.95 | 89.3 | 89.25 | 89.23 | 88.23 | 88.75 | 90.25 | 88.91 | 89.5 | 89.62 |
| Battery cell number | 16 | 17 | 18 | 19 | 20 | 21 | 22 | 23 | 24 | 25 | 26 | 27 | 28 | 29 | 30 |
| Capacity y/Ah | 89.3 | 89.32 | 89.62 | 89.41 | 89.25 | 89.63 | 89.74 | 89.54 | 89.52 | 89.1 | 89.36 | 89 | 89.44 | 89.25 | 89.21 |
| Battery cell number | 31 | 32 | 33 | 34 | 35 | 36 | 37 | 38 | 39 | 40 | 41 | 42 | 43 | 44 | 45 |
| Capacity y/Ah | 89.66 | 89.85 | 89.75 | 89.94 | 89.69 | 90.2 | 90.12 | 89.05 | 88.98 | 87.6 | 88.65 | 88.78 | 89.63 | 88.76 | 88.65 |
| Battery cell number | 46 | 47 | 48 | 49 | 50 | 51 | 52 | 53 | 54 | 55 | 56 | 57 | 58 | 59 | 60 |
| Capacity y/Ah | 89.33 | 89.65 | 89.32 | 89.62 | 89.41 | 89.25 | 90.12 | 89.05 | 88.98 | 88.75 | 90.12 | 90.25 | 89.74 | 89.54 | 89.52 |
| Battery cell number | 61 | 62 | 63 | 64 | 65 | 66 | 67 | 68 | 69 | 70 | 71 | 72 | 73 | 74 | 75 |
| Capacity y/Ah | 89.64 | 89.25 | 89.63 | 89 | 89.44 | 89.25 | 89.21 | 89.41 | 89.25 | 90.12 | 89.05 | 88.98 | 88.5 | 87.96 | 88.96 |
| Battery cell number | 76 | 77 | 78 | 79 | 80 | 81 | 82 | 83 | 84 | 85 | 86 | 87 | 88 | 89 | 90 |
| Capacity y/Ah | 88.65 | 88.78 | 89.63 | 89.69 | 90.2 | 90.12 | 89.05 | 89.75 | 89.94 | 89.74 | 89.54 | 89.52 | 88.75 | 90.12 | 88.91 |
| Battery cell number | 91 | 92 | 93 | 94 | 95 | 96 | 97 | 98 | 99 | 100 | 101 | 102 | 103 | 104 | |
| Capacity y/Ah | 89.41 | 89.25 | 90.12 | 89.05 | 89.62 | 89.41 | 89.25 | 88.98 | 88.75 | 89.32 | 89.62 | 89.41 | 89.25 | 89.66 | |

In the method for estimating the capacity of the battery cell according to the embodiments of the present disclosure, the actual capacity of the battery cell can be accurately calculated by comparing the actual charging voltage curve of the battery cell with the corresponding reference charging voltage curve of the battery cell. Since the pre-calibrated standard reference charging voltage curve is used, the actual capacity of the battery cell can be accurately obtained through the comparison based on the voltage curve, avoiding an influence of the battery system on the estimation result, which is effectively applicable to a plurality of battery systems. At the same time, the estimation method according to the embodiments of the present disclosure can be deployed in the server, and calculation efficiency is improved by using computing resources of the server. The root-mean-square error can be calculated by using the actual charging voltage curve and the reference charging voltage curve, and the objective function is determined by using the root-mean-square error; and the actual capacity of the battery cell is calculated by using the least squares method for the optimal solution. The total charging time period of the reference battery cell can be divided into the different charging stages. The interval identifiers are set for the SOC intervals of the different charging stages. The mathematical expressions of the different SOC intervals are established. The actual charging voltage curve and the corresponding reference charging voltage curve are further extracted by using the mathematical expressions. The root-mean-square error is calculated based on the respective mathematical expressions of the actual charging voltage curve and the reference charging voltage curve of each SOC interval. The charging test matrix can be constructed from the two dimensions of the temperature and the charging current. The interpolation is performed on the charging voltage curves at the different charging temperatures and the different charging rates that are obtained by means of the charging matrix to obtain the plurality of reference charging voltage curves. The voltage feature database is constructed by using the plurality of reference charging voltage curves and the SOC intervals to facilitate the subsequent lookup of the corresponding reference charging voltage curves based on the SOC intervals. The interpolation can be performed on the charging voltage curves at the different charging rates, and the reference charging voltage curve corresponding to the charging voltage at the arbitrary charging current is calculated with the formula. The interpolation can be performed on the charging voltage curves at the different temperatures, and the reference charging voltage curve corresponding to the voltage curve at the arbitrary temperature is calculated with the formula.

FIG. 5 is another flowchart of a method for estimating a capacity of a battery cell according to an embodiment of the present disclosure.

As shown in FIG. 5, the method for estimating the capacity of the battery cell is applied in a server and includes operations at steps S201 to S203.

In step S201, a charging test matrix of temperature and charging current is constructed.

A method for constructing the charging test matrix has been described in the above embodiments, and details thereof will not be described herein.

At step S202, charging voltage curves at different charging temperatures and/or different charging rates are acquired based on the charging test matrix, and interpolation is performed on the charging voltage curves at the different temperatures and/or the different charging rates to obtain a reference charging voltage curve of each SOC interval.

It can be understood that in the embodiment of the present disclosure, the charging voltage curves at the different charging temperatures and the different charging rates are acquired based on the charging test matrix, and then the interpolation is performed to obtain the reference charging voltage curve of each SOC interval. The interpolation method has been described in the above embodiments, and details thereof will not be described herein.

In step S203, a voltage feature database is constructed based on the reference charging voltage curve of each SOC interval, the reference charging voltage curve of each SOC interval is queried by using the voltage feature database, and an actual capacity of the battery cell is calculated based on an actual charging voltage curve and the reference charging voltage curve of each SOC interval.

The voltage feature database stores the relationship between the SOC interval and the reference charging voltage curve, and the reference charging voltage curve corresponding to the SOC interval can be queried by using the voltage feature database.

It can be understood that in the embodiment of the present disclosure, the reference charging voltage curve of each SOC interval can be queried by using the voltage feature database, the actual capacity and the initial SOC of the battery cell are calculated based on the actual charging voltage curve and the corresponding reference charging voltage curve of each SOC interval, and the corresponding actual SOC of the battery cell during the charging process is calculated by using the actual capacity and the initial SOC. The specific calculation method has been described in the above embodiments, and details thereof will not be described herein.

In the method for estimating the capacity of the battery cell according to the embodiments of the present disclosure, the charging test matrix is constructed from the two dimensions of the temperature and the charging current; the charging voltage curves at the different charging temperatures and the different charging rates are acquired; the interpolation is performed on the charging voltage curves to obtain the reference charging voltage curves; the actual capacity of the battery cell is calculated based on the actual charging voltage curve and the reference charging voltage curve of the battery cell within each SOC interval; and the calculation method is deployed on the server, which is not affected by the battery system and can accurately calculate the capacity of each battery cell in the battery pack.

Next, a device for estimating a capacity of a battery cell according to an embodiment of the present disclosure will be described with reference to the accompanying drawings.

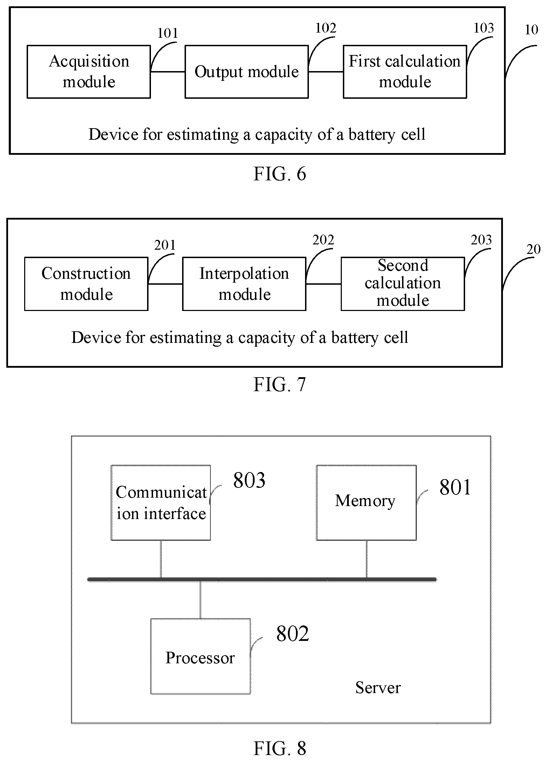

FIG. 6 is a block diagram of a device for estimating a capacity of a battery cell according to an embodiment of the present disclosure.

As shown in FIG. 6, a device 10 for estimating a capacity of a battery cell includes an acquisition module 101, an output module 102, and a first calculation module 103.

The acquisition module 101 is configured to acquire actual charging data of the battery cell within one or more SOC intervals.

The output module 102 is configured to generate, based on the actual charging data within each of one or more SOC intervals, an actual charging voltage curve of a corresponding SOC interval, generate actual charging voltage curves corresponding to the SOC intervals based on the actual charging data, query a pre-established voltage feature database with each of the one or more SOC intervals as an index, and output a reference charging voltage curve of each of the one or more SOC interval curves. The first calculation module 103 is configured to calculate an actual capacity of the battery cell based on the actual charging voltage curve and the reference charging voltage curve of each of one or more SOC intervals.

In an embodiment of the present disclosure, the first calculation module 103 is further configured to: calculate a root-mean-square error of the battery cell based on the actual charging voltage curve and the reference charging voltage curve of each of the one or more SOC intervals, and determine an objective function based on the root-mean-square error; and find, by using a least squares method, an optimal solution to the objective function to obtain the actual capacity of the battery cell.

In an embodiment of the present disclosure, the first calculation module 103 is further configured to: calculate a root-mean-square error of the battery cell based on the actual charging voltage curve and the reference charging voltage curve of each of the one or more SOC intervals, and determine an objective function based on the root-mean-square error; and find, by using a least squares method, an optimal solution to the objective function to obtain the actual capacity of the battery cell.

In an embodiment of the present disclosure, the device 10 of the present disclosure further includes a processing module.

The processing module is configured to: prior to the querying the pre-established voltage feature database, construct a charging test matrix of temperature and charging current; acquire, based on the charging test matrix, charging voltage curves at different charging temperatures and/or different charging rates, and perform interpolation on the charging voltage curves at the different temperatures and/or the different charging rates to obtain a plurality of reference charging voltage curves; and construct the voltage feature database based on each of the one or more SOC intervals and a corresponding one of the plurality of reference charging voltage curves.

In an embodiment of the present disclosure, the processing module is further configured to: calculate a maximum charging capacity corresponding to all the charging voltage curves at the different rates; determine, based on the maximum charging capacity, a step size of a capacity interval corresponding to each of all the charging voltage curves, and divide the capacity interval into a plurality of grids based on the step size; and calculate a first constant based on a voltage of each of the plurality of grids, acquire, based on the first constant, a charging voltage at an arbitrary charging current, and generate the plurality of reference charging voltage curves based on the charging voltage at the arbitrary charging current.

In an embodiment of the present disclosure, the processing module is further configured to: calculate a maximum charging capacity corresponding to all the charging voltage curves at the different temperatures; determine, based on the maximum charging capacity, a step size of a capacity interval corresponding to each of all the charging voltage curves, and divide the capacity interval into a plurality of grids based on the step size; and calculate a second constant based on a voltage of each of the plurality of grids, acquire, based on the second constant, a voltage curve at an arbitrary temperature, and obtain the plurality of reference charging voltage curves based on the voltage curve at the arbitrary temperature.

In an embodiment of the present disclosure, the processing module is further configured to: at a predetermined temperature, perform constant current discharging with a first predetermined current until a predetermined cut-off voltage is reached, switch to a second predetermined current to perform the constant current discharging until the predetermined cut-off voltage is reached, stand for a first predetermined duration, perform the constant current charging with a third predetermined current until the predetermined cut-off voltage is reached, and record a charging voltage curve at a current temperature and/or a current charging rate; and stand for a second predetermined duration, perform the constant current discharging with a fourth predetermined current until the predetermined cut-off voltage is reached, switch to a fifth predetermined current to perform the constant current discharging until the predetermined cut-off voltage is reached, stand for a third predetermined duration, and re-perform a charging test at other charging rates and/or other charging temperatures.

It should be noted that the above illustration of the embodiments of the method for estimating the capacity of the battery cell is also applicable to the embodiment of the device for estimating the capacity of the battery cell, and details thereof will not be described herein.

In the device for estimating the capacity of the battery cell according to the embodiments of the present disclosure, the actual capacity of the battery cell can be accurately calculated by comparing the actual charging voltage curve of the battery cell with the corresponding reference charging voltage curve of the battery cell. Since the pre-calibrated standard reference charging voltage curve is used, the actual capacity of the battery cell can be accurately obtained through the comparison based on the voltage curve, avoiding an influence of the battery system on the estimation result, which is effectively applicable to a plurality of battery systems. At the same time, the estimation method according to the embodiments of the present disclosure can be deployed in the server, and calculation efficiency is improved by using computing resources of the server. The root-mean-square error can be calculated by using the actual charging voltage curve and the reference charging voltage curve, and the objective function is determined by using the root-mean-square error; and the actual capacity of the battery cell is calculated by using the least squares method for the optimal solution. The total charging time period of the reference battery cell can be divided into the different charging stages. The interval identifiers are set for the SOC intervals of the different charging stages. The mathematical expressions of the different SOC intervals are established. The actual charging voltage curve and the corresponding reference charging voltage curve are further extracted by using the mathematical expressions. The root-mean-square error is calculated based on the respective mathematical expressions of the actual charging voltage curve and the reference charging voltage curve of each SOC interval. The charging test matrix can be constructed from the two dimensions of the temperature and the charging current. The interpolation is performed on the charging voltage curves at the different charging temperatures and the different charging rates that are obtained by means of the charging matrix to obtain the plurality of reference charging voltage curves. The voltage feature database is constructed by using the plurality of reference charging voltage curves and the SOC intervals to facilitate the subsequent lookup of the corresponding reference charging voltage curves based on the SOC intervals. The interpolation can be performed on the charging voltage curves at the different charging rates, and the reference charging voltage curve corresponding to the charging voltage at the arbitrary charging current is calculated with the formula. The interpolation can be performed on the charging voltage curves at the different temperatures, and the reference charging voltage curve corresponding to the voltage curve at the arbitrary temperature is calculated with the formula.

FIG. 7 is a block diagram of a device for estimating a capacity of a battery cell according to another embodiment of the present disclosure.

As shown in FIG. 7, a device 20 for estimating a capacity of a battery cell is applied in a server. The device 20 includes a construction module 201, an interpolation module 202, and a second calculation module 203.

The construction module 201 is configured to construct a charging test matrix of temperature and charging current. The interpolation module 202 is configured to acquire, based on the charging test matrix, charging voltage curves at different charging temperatures and/or different charging rates, and perform interpolation on the charging voltage curves at the different temperatures and/or the different charging rates to obtain a reference charging voltage curve of each SOC interval. The second calculation module 203 is configured to construct a voltage feature database based on the reference charging voltage curve of each SOC interval, query the reference charging voltage curve of each SOC interval by using the voltage feature database, and calculate an actual capacity of the battery cell based on an actual charging voltage curve and the reference charging voltage curve of each SOC interval.

It should be noted that the above illustration of the embodiments of the method for estimating the capacity of the battery cell is also applicable to the embodiment of the device for estimating the capacity of the battery cell, and details thereof will not be described herein.

It should be noted that the above illustration of the embodiments of the method for estimating the capacity of the battery cell is also applicable to the embodiment of the device for estimating the capacity of the battery cell, and details thereof will not be described herein.

In the device for estimating the capacity of the battery cell according to the embodiments of the present disclosure, the charging test matrix is constructed from the two dimensions of the temperature and the charging current; the charging voltage curves at the different charging temperatures and the different charging rates are acquired; the interpolation is performed on the charging voltage curves to obtain the reference charging voltage curves; the actual capacity of the battery cell is calculated based on the actual charging voltage curve and the reference charging voltage curve of the battery cell within each SOC interval; and the calculation method is deployed on the server, which is not affected by the battery system and can accurately calculate the capacity of each battery cell in the battery pack.

FIG. 8 is a schematic diagram of a structure of a server according to an embodiment of the present disclosure. The server may include a memory 801, a processor 802, and a computer program stored in the memory 801 and executable by the processor 802. The processor 802, when executing the program, implements the method for estimating the capacity of the battery cell in the above embodiments described above.

Further, the server further includes a communication interface 803. The communication interface 803 stores communication between the memory 801 and the processor 802. The memory 801 stores a computer program executable by the processor 802. The memory 801 may include a high-speed RAM (Random Access Memory), and may also include a nonvolatile memory, such as at least one disk memory.

If the memory 801, the processor 802, and the communication interface 803 are implemented independently, the communication interface 803, the memory 801, and the processor 802 can be connected to each other via a bus and communicate with each other. The bus can be an ISA (Industry Standard Architecture) bus, a PCI (Peripheral Component) bus, or an EISA (Extended Industry Standard Architecture) bus, etc. The bus can be divided into an address bus, a data bus, a control bus, etc. For ease of representation, only one thick line is used in FIG. 8, but it does not mean that there is only one bus or one type of bus.

Optionally, in a specific implementation, if the memory 801, the processor 802, and the communication interface 803 are integrated on a chip, the memory 801, the processor 802, and the communication interface 803 can communicate with each other via an internal interface.

The processor 802 can be a CPU (Central Processing Unit), or an ASIC (Application Specific Integrated Circuit), or one or more integrated circuits configured to implement the embodiments of the present disclosure.

Embodiments of the present disclosure also provide a computer-readable storage medium. The medium has a computer program stored thereon. The program, when executed by a processor, implements the method for estimating the capacity of the battery cell as described above.

Reference throughout this specification to "an embodiment", "some embodiments", "an example", "a specific example", or "some examples" means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Furthermore, the particular features, structures, materials, or characteristics may be combined in any suitable manner in one or N embodiments or examples. In addition, different embodiments or examples and features of different embodiments or examples described in the specification may be combined by those skilled in the art without mutual contradiction.

In addition, the terms such as "first" and "second" are used herein for purposes of description and are not intended to indicate or imply relative importance, or to implicitly show the number of technical features indicated. Thus, the feature defined with "first" and "second" may explicitly or implicitly comprise one or more this feature. In the description of the present disclosure, "N" means at least two, for example, two or three, unless specified otherwise.

Any process or method described in a flow chart or described herein in other ways may be understood to include one or more modules, segments or portions of codes of executable instructions for achieving specific logical functions or steps in the process, and the scope of a preferred embodiment of the present disclosure includes other implementations. Functions may be executed in a different order from the illustrated or discussed order, and may be executed, depending on functions involved, substantially in parallel with each or in a reverse order, which should be understood by those skilled in the art of the embodiments of the present disclosure.

It should be understood that each part of the present disclosure may be realized by the hardware, software, firmware or their combination. In the above embodiments, N steps or methods may be realized by the software or firmware stored in the memory and executed by the appropriate instruction execution system. For example, if it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a programmable gate array, a field programmable gate array, etc.

It would be understood by those skilled in the art that all or a part of the steps carried by the method in the above-mentioned embodiments may be completed by relevant hardware instructed by a program. The program may be stored in a computer readable storage medium. When the program is executed, one or a combination of the steps of the method in the above-mentioned embodiments may be implemented.

**Claims**

1. A method for estimating a capacity of a battery cell, the method being applied in a server, and the method comprising:

   acquiring actual charging data of the battery cell within one or more Stage of Charge, SOC, intervals;
   generating, based on the actual charging data within each of the one or more SOC intervals, an actual charging voltage curve of a corresponding SOC interval, querying a pre-established voltage feature database with each of the one or more SOC intervals as an index, and outputting a reference charging voltage curve of each of the one or more SOC intervals; and
   calculating an actual capacity of the battery cell based on the actual charging voltage curve and the reference charging voltage curve of each of the one or more SOC intervals.

2. The method for estimating the capacity of the battery cell according to claim 1, wherein said calculating the actual capacity of the battery cell based on the actual charging voltage curve and the reference charging voltage curve of each of the one or more SOC intervals comprises:

> calculating a root-mean-square error of the battery cell based on the actual charging voltage curve and the reference charging voltage curve of each of the one or more SOC intervals, and determining an objective function based on the root-mean-square error; and
> finding, by using a least squares method, an optimal solution to the objective function to obtain the actual capacity of the battery cell.

3. The method for estimating the capacity of the battery cell according to claim 2, wherein said calculating the root-mean-square error of the battery cell based on the actual charging voltage curve and the reference charging voltage curve of each of the one or more SOC intervals comprises:

> dividing a total charging time period of a reference battery cell into different charging stages;
> adding an interval identifier to a SOC interval corresponding to each of the different charging stages, and establishing a mathematical expression among SOC interval, SOC, and capacity based on the interval identifier; and
> extracting the actual charging voltage curve and the corresponding reference charging voltage curve by using the mathematical expression, and calculating the root-mean-square error of the battery cell based on respective mathematical expressions of the actual charging voltage curve and the reference charging voltage curve of each of the one or more SOC intervals.

4. The method for estimating the capacity of the battery cell according to claim 1, further comprising, prior to said querying the pre-established voltage feature database:

> constructing a charging test matrix of temperature and charging current;
> acquiring, based on the charging test matrix, charging voltage curves at different charging temperatures and/or different charging rates, performing interpolation on the charging voltage curves at the different temperatures and/or the different charging rates to obtain a plurality of reference charging voltage curves; and
> constructing the voltage feature database based on each of the one or more SOC intervals and a corresponding one of the plurality of reference charging voltage curves.

5. The method for estimating the capacity of the battery cell according to claim 4, wherein said performing the interpolation on the charging voltage curves at the different temperatures and/or the different charging rates to obtain the plurality of reference charging voltage curves comprises:

> calculating a maximum charging capacity corresponding to all the charging voltage curves at the different rates;
> determining, based on the maximum charging capacity, a step size of a capacity interval corresponding to each of all the charging voltage curves, and dividing the capacity interval into a plurality of grids based on the step size; and
> calculating a first constant based on a voltage of each of the plurality of grids, acquiring, based on the first constant, a charging voltage at an arbitrary charging current, and generating the plurality of reference charging voltage curves based on the charging voltage at the arbitrary charging current.

6. The method for estimating the capacity of the battery cell according to claim 4, wherein said performing the interpolation on the charging voltage curves at the different temperatures and/or the different charging rates to obtain the plurality of reference charging voltage curves comprises:

> calculating a maximum charging capacity corresponding to all the charging voltage curves at the different temperatures;
> determining, based on the maximum charging capacity, a step size of a capacity interval corresponding to each of all the charging voltage curves, and dividing the capacity interval into a plurality of grids based on the step size; and
> calculating a second constant based on a voltage of each of the plurality of grids, acquiring, based on the second constant, a voltage curve at an arbitrary temperature, and obtaining the plurality of reference charging voltage curves based on the voltage curve at the arbitrary temperature.

7. The method for estimating the capacity of the battery cell according to claim 4, wherein said acquiring, based on the charging test matrix, the charging voltage curves at the different charging temperatures and/or the different charging rates comprises:

at a predetermined temperature, performing constant current discharging with a first predetermined current until a predetermined cut-off voltage is reached, switching to a second predetermined current to perform the constant current discharging until the predetermined cut-off voltage is reached, standing for a first predetermined duration, performing the constant current charging with a third predetermined current until the predetermined cut-off voltage is reached, and recording a charging voltage curve at a current temperature and/or a current charging rate; and

standing for a second predetermined duration, performing the constant current discharging with a fourth predetermined current until the predetermined cut-off voltage is reached, switching to a fifth predetermined current to perform the constant current discharging until the predetermined cut-off voltage is reached, standing for a third predetermined duration, and re-performing a charging test at other charging rates and/or other charging temperatures.

8. A method for estimating a capacity of a battery cell, the method being applied in a server, and the method comprising:

constructing a charging test matrix of temperature and charging current;
acquiring, based on the charging test matrix, charging voltage curves at different charging temperatures and/or different charging rates, performing interpolation on the charging voltage curves at the different temperatures and/or the different charging rates to obtain a reference charging voltage curve of each SOC interval; and constructing a voltage feature database based on the reference charging voltage curve of each SOC interval, querying the reference charging voltage curve of each SOC interval by using the voltage feature database, and calculating an actual capacity of the battery cell based on an actual charging voltage curve and the reference charging voltage curve of each SOC interval.

9. A device for estimating a capacity of a battery cell, the device being applied in a server, and the device comprising:

an acquisition module configured to acquire actual charging data of the battery cell within one or more SOC intervals;
an output module configured to generate, based on the actual charging data within each of one or more SOC intervals, an actual charging voltage curve of a corresponding SOC interval, generate actual charging voltage curves corresponding to the SOC intervals based on the actual charging data, query a pre-established voltage feature database with each of the one or more SOC intervals as an index, and output a reference charging voltage curve of each of the one or more SOC intervals; and
a first calculation module configured to calculate an actual capacity of the battery cell based on the actual charging voltage curve and the reference charging voltage curve of each of one or more SOC intervals.

10. A device for estimating a capacity of a battery cell, the device being applied in a server, and the device comprising:

a construction module configured to construct a charging test matrix of temperature and charging current;
an interpolation module configured to acquire, based on the charging test matrix, charging voltage curves at different charging temperatures and/or different charging rates, and perform interpolation on the charging voltage curves at the different temperatures and/or the different charging rates to obtain a reference charging voltage curve of each SOC interval; and
a second calculation module configured to construct a voltage feature database based on the reference charging voltage curve of each SOC interval, query the reference charging voltage curve of each SOC interval by using the voltage feature database, and calculate an actual capacity of the battery cell based on an actual charging voltage curve and the reference charging voltage curve of each SOC interval.

11. A server, comprising:

a memory;
a processor; and
a computer program stored in the memory and executable by the processor,
wherein the processor is configured to execute the computer program to implement the method for estimating the capacity of the battery cell according to any one of claims 1 to 8.

12. A computer-readable storage medium, having a computer program stored thereon, wherein the computer program is configured to be executed by a processor to implement the method for estimating the capacity of the battery cell according to any one of claims 1 to 8.

| | |
|---|---|
| Acquire actual charging data of the battery cell within one or more SOC intervals | S101 |
| Generate, based on the actual charging data within each of the one or more SOC intervals, an actual charging voltage curve of a corresponding SOC interval, query a pre-established voltage feature database with each of the one or more SOC intervals as an index, and output a reference charging voltage curve of each of the one or more SOC intervals | S102 |
| calculate an actual capacity of the battery cell based on the actual charging voltage curve and the reference charging voltage curve of each of the one or more SOC intervals | S103 |

FIG. 1

FIG. 2

Construct feature database $V=f(I,T,x)$ of an LFP cell among charging voltage, current, temperature, and SOC — S1

Divide, based on a numerical change of the actual charging current of the battery, a total charging time period into different charging stages $t_1$, $t_2$, $t_3$, $t_4$..., and label SOC intervals corresponding to the different charging stages of each battery cell as $\theta_1^i$, $\theta_2^i$, $\theta_3^i$, $\theta_4^i$.... — S2

Establish mathematical expressions of the different SOC intervals $\theta_1^i$, $\theta_2^i$, $\theta_3^i$, $\theta_4^i$.... — S3

Extract actual charging voltage curves ($V_1^i(\theta_1^i)$, $V_2^i(\theta_2^i)$, $V_3^i(\theta_3^i)$, $V_4^i(\theta_4^i)$,...) corresponding to each battery cell (i) in different charging SOC intervals — S4

Query a standard voltage curve through the feature database $V=f(I,T,x)$; determine a root-mean-square error of $V_1^i(\theta_1)$, $V_2^i(\theta_2)$, $V_3^i(\theta_3)$, $V_4^i(\theta_4)$, ... and the standard voltage curve as an objective function; and calculate actual capacity $Q_0^i$ of each battery cell by using a least squares method. — S5

FIG. 3

FIG. 4

Construct a charging test matrix of temperature and charging current — S201

Acquire, based on the charging test matrix, charging voltage curves at different charging temperatures and/or different charging rates, and perform interpolation on the charging voltage curves at the different temperatures and/or the different charging rates to obtain a reference charging voltage curve of each SOC interval — S202

Construct a voltage feature database based on the reference charging voltage curve of each SOC interval, query the reference charging voltage curve of each SOC interval by using the voltage feature database, and calculate an actual capacity of the battery cell based on an actual charging voltage curve and the reference charging voltage curve of each SOC interval — S203

FIG. 5

Acquisition module 101 — Output module 102 — First calculation module 103 — 10

Device for estimating a capacity of a battery cell

FIG. 6

Construction module 201 — Interpolation module 202 — Second calculation module 203 — 20

Device for estimating a capacity of a battery cell

FIG. 7

Communication interface 803

Memory 801

Processor 802

Server

FIG. 8

## INTERNATIONAL SEARCH REPORT

| International application No. |
| --- |
| **PCT/CN2023/123733** |

| A. | CLASSIFICATION OF SUBJECT MATTER |
| --- | --- |

G01R 31/367(2019.01)i; G01R 31/36(2020.01)i; G01R 31/396(2019.01)i; G01R 31/388(2019.01)i; G01R 31/389(2019.01)i

According to International Patent Classification (IPC) or to both national classification and IPC

| B. | FIELDS SEARCHED |
| --- | --- |

Minimum documentation searched (classification system followed by classification symbols)

IPC:G01R

Documentation searched other than minimum documentation to the extent that such documents are included in the fields searched

Electronic data base consulted during the international search (name of data base and, where practicable, search terms used)

CNTXT; CNKI; ENTXT; ENTXTC; VEN: 充电, 电压, 曲线, 数据库, 容量, 目标函数, 最优解, 均方根误差, 温度, 充电电流, 充电倍率, 插值, charge, voltage, curve, capacity, temperature, charge current, objective function, root mean square error, interpolation

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 116430242 A (DEEPBLUE AUTOMOTIVE TECHNOLOGIES CO., LTD.) 14 July 2023 (2023-07-14)<br>claims 1-12 | 1-12 |
| PX | CN 116430243 A (DEEPBLUE AUTOMOTIVE TECHNOLOGIES CO., LTD.) 14 July 2023 (2023-07-14)<br>claims 1-12 | 1-12 |
| X | CN 115616421 A (CHONGQING CHANG'AN NEW ENERGY AUTOMOBILE TECHNOLOGY CO., LTD.) 17 January 2023 (2023-01-17)<br>claims 1-12, and description, paragraphs 76-153 | 1-12 |
| A | CN 112305433 A (CONTEMPORARY AMPEREX TECHNOLOGY CO., LTD.) 02 February 2021 (2021-02-02)<br>entire document | 1-12 |
| A | CN 114609523 A (CRRC ELECTRIC VEHICLE CO., LTD.) 10 June 2022 (2022-06-10)<br>entire document | 1-12 |

☑ Further documents are listed in the continuation of Box C.  ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **26 February 2024** | **26 February 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2023/123733** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 116106768 A (ZHUHAI COSMX POWER CO., LTD.) 12 May 2023 (2023-05-12) entire document | 1-12 |
| A | KR 101930646 B1 (POSCO ICT CO., LTD.) 11 March 2019 (2019-03-11) entire document | 1-12 |
| A | WO 2023042456 A1 (OMRON TATEISI ELECTRONICS CO.) 23 March 2023 (2023-03-23) entire document | 1-12 |

Form PCT/ISA/210 (second sheet) (July 2022)

**INTERNATIONAL SEARCH REPORT**
Information on patent family members

International application No.

**PCT/CN2023/123733**

| Patent document cited in search report | | | Publication date (day/month/year) | Patent family member(s) | | | Publication date (day/month/year) |
|---|---|---|---|---|---|---|---|
| CN | 116430242 | A | 14 July 2023 | None | | | |
| CN | 116430243 | A | 14 July 2023 | None | | | |
| CN | 115616421 | A | 17 January 2023 | None | | | |
| CN | 112305433 | A | 02 February 2021 | None | | | |
| CN | 114609523 | A | 10 June 2022 | None | | | |
| CN | 116106768 | A | 12 May 2023 | None | | | |
| KR | 101930646 | B1 | 11 March 2019 | None | | | |
| WO | 2023042456 | A1 | 23 March 2023 | JP | 2023042959 | A | 28 March 2023 |

Form PCT/ISA/210 (patent family annex) (July 2022)

## EP 4 564 030 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310640090X